# EUROPÄISCHE PATENTSCHRIFT

(11) **EP 1 449 416 B1**
(45) Veröffentlichungstag und Bekanntmachung des Hinweises auf die Patenterteilung: **31.08.2005**
(21) Anmeldenummer: 02782758.3
(22) Anmeldetag: 04.11.2002
(51) Int. Cl.: H05K 13/04

(54) **MONTAGEVORRICHTUNG FÜR BAUTEILE MIT EINEM SAUGGREIFER**
ASSEMBLY DEVICE FOR COMPONENTS COMPRISING A VACUUM GRIPPER
DISPOSITIF DE MONTAGE POUR COMPOSANTS COMPRENANT UNE PINCE ASPIRANTE

(30) Priorität: 29.11.2001 DE 10158695
(43) Veröffentlichungstag der Anmeldung: 25.08.2004
(73) Patentinhaber: SIEMENS AKTIENGESELLSCHAFT, 80333 München (DE)
(72) Erfinder: ANDERSCH, Walter, 85551 Kirchheim (DE)
(86) Internationale Anmeldenummer: PCT/DE2002/004086
(87) Internationale Veröffentlichungsnummer: WO 2003/049523

(56) Entgegenhaltungen:
- EP-A1- 1 194 028
- JP-A- 2001 267 795
- JP-A- 2002 137 185

## Beschreibung

Die Erfindung bezieht sich auf eine Montagevorrichtung für Bauteile mit zumindest einem positionierbaren Montagekopf für die Bauteile, mit einer einem Sauggreifer des Montagekopfs zugeordneten luftatmenden Strahlpumpe zum Erzeugen von Vakuum für den Sauggreifer sowie mit zumindest einer thermisch belasteten, dem Montagekopf zugeordneten Funktionseinheit, wobei die Strahlpumpe eine Austrittsöffnung für die entweichende Abluft aufweist, insbesondere bei einer Vorrichtung zum Bestücken von Substraten mit elektrischen Bauelementen.

Zum Beispiel beim Bestücken von Leiterplatten mit elektrischen Bauelementen ist es üblich, die Bauelemente mit einem Vakuumgreifer eines positionierbaren Bestückkopfes an einer Zuführeinrichtung für die Bauelemente abzuholen und zu einem vorbestimmten Platz auf der Leiterplatte zu transportieren.

Durch die EP 0 768 020 B ist bekannt, das dafür erforderliche Vakuum mittels einer dem Bestückkopf zugeordneten Strahlpumpe zu erzeugen. Es ist üblich, die dafür erforderliche Druckluft einer im Gebäude vorhandenen Druckluftanlage zu entnehmen und über Schläuche dem Bestückkopf zuzuführen. Die Strahlpumpe besteht im Wesentlichen aus einer Venturidüse, an deren engster Stelle eine Saugluftleitung angeschlossen ist. Das Querschnittsprofil der Venturidüse ist so ausgebildet, dass die aus dem Hauptstromkanal austretende Luft nur noch einen geringen Überdruck aufweist. Dieser wird benötigt, um den Strömungswiederstand eines angeschlossenen Schalldämpfers überwinden zu können.

Durch die DE 19857331 C ist eine Bestückvorrichtung für Substrate mit einem in zwei Koordinatenrichtungen verfahrbaren Bestückkopf bekannt geworden, der über eine Druckleitung mit Druckluft versorgt wird, die mittels einer Saugpumpe im Bestückkopf in Saugluft umgewandelt wird. Der Bestückkopf ist an einem linear verfahrbaren Positionierarm geführt, der mittels eines Linearmotors angetrieben wird. Um dessen Abwärme vom Positionierarm fernzuhalten, sind in der Nähe des Linearmotors in einem Fußteil des Positionierarms Bohrungen vorgesehen, durch die die Druckluft hindurchgeführt wird, die sich dabei erwärmt.

Durch die EP 1 121 010 A ist ferner ein Bestückkopf bekannt geworden, der mittels eines Linearmotors entlang einer Linearführung verfahrbar ist. Der Bestückkopf weist einen Revolver auf, an dem sternförmig abstehende Greifer in getaktetem Umlauf mittels eines Elektromotors verdreht werden können. Um einen solchen Bestückkopf mit hoher Taktfrequenz und entsprechend großen Beschleunigungen bzw. Verzögerungen betreiben zu können, ist anzustreben, die beweglichen Massen so gering wie möglich zu halten. Das bedeutet, dass die elektrischen Antriebe möglichst klein und leicht gehalten werden müssen, was zu einer hohen Wärmebelastung führen kann. Beispielsweise muss die am Bestückkopf befestigte Spuleneinheit des Linearmotors nicht nur die Beschleunigungs- sondern auch die Brems- und Haltekräfte aufbringen und entsprechend bestromt werden. Die gesamte aufgenommene Energie wird in Wärme umgesetzt, die sich auf die gesamte nähere Umgebung auswirkt. Die damit verbundenen Temperaturschwankungen an den positionsgebenden Teilen können zu Verformungen führen, die die Positioniergenauigkeit der Einrichtung beeinträchtigen und auch zu Verspannungen in den Führungen und Lagern führen, die die Lebensdauer verringern.

Es ist zwar bekannt, die elektrischen Antriebe mit Kühlrippen und Kühlkanälen zu versehen, die z. B. im Luftstrom der Verfahrbewegungen den Wärmeaustausch verbessern. Da die Antriebe aber im Inneren eines geschlossenen Gehäuses liegen, erhöht sich die Umgebungstemperatur auch mit negativen Auswirkungen auf andere Antriebe und Positioniereinrichtungen, was auch für ein mitfahrendes Kühlgebläse zutrifft.

Der Erfindung liegt die Aufgabe zugrunde, die thermischen Verhältnisse zu verbessern.

Diese Aufgabe wird durch die Erfindung gemäß Anspruch 1 gelöst. Durch die Verwendung der Abluft der Strahlpumpe zum Kühlen der elektrischen Einrichtungen am Bestückkopf werden keine zusätzlichen Leitungen oder Gebläse benötigt. Die für die Strahlpumpe erforderliche Druckluft wird in aller Regel einer externen Druckluftanlage entnommen, bei der die komprimierte Luft bereits auf Umgebungstemperatur abgekühlt wird, bevor sie in die Leitungen gelangt. In der Strahlpumpe entspannt sich die Druckluft von z. B. 4,5 bar auf 1,2 bar, wobei sich die entspannte Luft unter das Niveau der Umgebungstemperatur abkühlt. Dadurch erwärmt sie sich beim Aufnehmen der Verlustwärme der Antriebe auf ein Niveau, das nur wenig über dem der Umgebungstemperatur liegt. Die Antriebe werden so gut gekühlt, dass ihre Abmessungen erheblich verkleinert werden können, ohne dass es zu einer internen Überhitzung kommt. Die externe Luftzufuhr führt zu einer Verdrängung der im Gehäuse befindlichen Luft, wobei die heißen Regionen besonders gut durchspült werden und deren Abwärme mit nach außen transportiert wird.

Vorteilhafte Weiterbildungen der Erfindung sind in den Ansprüchen 2 bis 7 gekennzeichnet.

Die Weiterbildung nach Anspruch 2 geht davon aus, dass elektronische Einrichtungen mehr und mehr dezentral angeordnet werden. Beispielsweise ist es möglich, die Bilddaten einer an am Montagekopf befindlichen Kamera mittels einer im Kopf befindlichen Elektronik aufzubereiten und im reduzierten Umfang an eine externe Elektronik weiterzuleiten. Eine solche Elektronikeinheit benötigt einen leistungsstarken Prozessor, der thermisch hoch belastet sein kann. Ein solcher Prozessor kann ohne nennenswerten Zusatzaufwand mit Hilfe der Abluft der Strahlpumpe gekühlt werden.

Das gleiche gilt für die Antriebseinheit nach den Ansprüchen 3 bis 5, die ein möglichst geringes Leistungsgewicht aufweisen soll, was mit einer effektiven Kühlung erreicht wird.

Bei einem Montagekopf, der keinen eigenen Antrieb aufweist, sondern z. B. mittels eines Zahnriemens in einer Linearführung verschoben wird, ist es nach Anspruch 6 möglich, die Abluft zur Kühlung des möglichst kompakten Drehantriebs für den Revolver zu nutzen.

Der Verteiler nach Anspruch 7 ermöglicht die gleichzeitige Kühlung mehrerer elektrische Verbraucher zum Beispiel des Linearantriebs und des Drehantriebs.

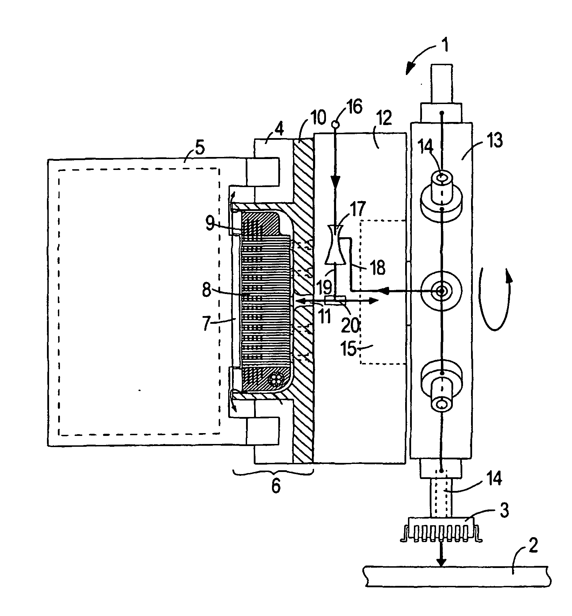

Im folgenden wird die Erfindung anhand eines in der Zeichnung dargestellten Ausführungsbeispiels näher erläutert.

Die dargestellte Figur zeigt schematisiert eine Seitenansicht eines Montagekopfs 1 nach der Erfindung zum Bestücken von Substraten 2 mit elektrischen Bauelementen 3. Der Montagekopf 1 ist in einer Linearführung 4 senkrecht zur Bildebene an einem Positionierarm 5 mittels eines Linearmotors verschiebbar, der aus einer Spuleneinheit 6 und einer Magnetbahn 7 gebildet ist, die sich am Positionierarm 5 in der Richtung der Linearführung 4 erstreckt. Die Spuleneinheit 6 besteht aus einem mit vergossenen Spulen 8 belegten Eisenkern 9 und einem umhüllenden Gehäuse 10. Zwischen dem Eisenkern 9 mit einer Vergussmasse für die Spulen und der Gehäuseinnenwand ist umlaufend ein durchgehender enger Spalt ausgebildet, der über eine Einlassöffnung 11 mit dem Montagekopf 1 verbunden ist.

Der Montagekopf weist einen Stator 12 auf, an dem ein Revolver 13 mit sternförmig abstehenden Sauggreifern 14 drehbar gelagert ist. Der Revolver 13 kann mittels eines motorischen Drehantriebs 15 schrittweise so gedreht werden, dass jeweils eines der Bauelemente 3 in eine Aufsetzlage über dem Substrat 2 gelangt und auf diesem abgesetzt werden kann. Der Stator 12 ist mit einer an eine Druckluftleitung 16 angeschlossenen Strahlpumpe 17 versehen, die über eine Saugleitung 18 mit den Sauggreifern 14 verbunden ist.

Der Hauptstromkanal der düsenförmigen Strahlpumpe 17 mündet in eine Luftleiteinrichtung 19 in Form eines Luftleitkanals, der sich in einem Verteiler 20 in zwei Richtungen verzweigt. Einer dieser Zweige führt in den elektrischen Drehantrieb 15 und kühlt diesen in nicht mehr dargestellter Weise. Der andere Zweig mündet in der Einlassöffnung 11 der Spuleneinheit 6 und verteilt sich von dort in den umgebenden Spalt entlang der Gehäuseinnenwand. Dieser ermöglicht eine große Wärmetauschfläche entlang dem Eisenkern 9 und der Vergussmasse für die Spulen 8 mit einer hohen Kühlwirkung. Der Spalt isoliert außerdem das Gehäuse thermisch gegenüber den erwärmten Eisenkern 9, so dass eine großflächige thermische Kopplung durch Wärmeleitung unterbunden ist.

Bezugszeichenliste
- 1: Montagekopf
- 2: Substrat
- 3: Bauelement
- 4: Linearführung
- 5: Positionierarm
- 6: Spuleneinheit
- 7: Magnetbahn
- 8: Spule
- 9: Eisenkern
- 10: Gehäuse
- 11: Einlassöffnung
- 12: Stator
- 13: Revolver
- 14: Sauggreifer
- 15: Drehantrieb
- 16: Druckluftleitung
- 17: Strahlpumpe
- 18: Saugleitung
- 19: Luftleiteinrichtung
- 20: Verteiler

## Patentansprüche

1. Montagevorrichtung für Bauteile mit zumindest einem positionierbaren Montagekopf (1) für die Bauteile, mit einer einem Sauggreifer (14) des Montagekopfs (1) zugeordneten luftatmenden Strahlpumpe (17) zum Erzeugen von Vakuum für den Sauggreifer (14) sowie mit zumindest einer thermisch belasteten, dem Montagekopf zugeordneten Funktionseinheit (6, 15), wobei die Strahlpumpe (17) eine Austrittsöffnung für die entweichende Abluft aufweist, insbesondere bei einer Vorrichtung zum Bestücken von Substraten (2) mit elektrischen Bauelementen (3),
**dadurch gekennzeichnet, dass** die aus der Ausrittsöffnung entweichende Abluft über eine Luftleiteinrichtung (19) zur thermisch belasteten Funktionseinheit geführt ist.

2. Montagevorrichtung nach Anspruch 1,
**dadurch gekennzeichnet, dass** die Funktionseinheit als Elektronikmodul ausgebildet ist.

3. Montagevorrichtung nach Anspruch 1 oder 2,
**dadurch gekennzeichnet, dass** die Funktionseinheit als den Bestückkopf (1) positionierende elektromotorische Antriebseinheit (6) ausgebildet ist.

4. Montagevorrichtung nach Anspruch 3,
**dadurch gekennzeichnet, dass** die Antriebseinheit als Spuleneinheit (6) eines Linearmotors ausgebildet ist.

5. Montagevorrichtung nach Anspruch 4,
**dadurch gekennzeichnet, dass** der verschiebbare Montagekopf (1) fest mit der Spuleneinheit (6) verbunden ist und
dass die Luftleiteinrichtung (19) im Montagekopf (1) als Luftleitkanal ausgebildet ist.

6. Montagevorrichtung nach einem der vorhergehenden Ansprüche,
**dadurch gekennzeichnet, dass** mehrere der Sauggreifer (14) an einem Revolver (13) des Montagekopfes (1) gehalten sind und
dass die Austrittsöffnung der Strahlpumpe (17) über die Luftleiteinrichtung (19) mit einem Drehantrieb (15) für den Revolver (13) verbunden ist.

7. Montagevorrichtung nach Anspruch 5,
**dadurch gekennzeichnet, dass** die Luftleiteinrichtung (19) einen Verteiler (20) zum Aufteilen der Abluft auf unterschiedliche Funktionseinheiten aufweist.

## Claims

1. Component mounting device with at least one positionable mounting head (1) for the components, a jet pump (17) assigned to a vacuum gripper (14) of the mounting head (1) for producing vacuum for the vacuum gripper (14) and at least one thermally loaded functional unit (6, 15) assigned to the mounting head, the jet pump (17) having an outlet port for the escaping exhaust air, in particular for a device for populating substrates (2) with electrical components (3),
**characterised in that** the exhaust air escaping from the outlet opening is fed to the thermally loaded functional unit via an air guide device (19).

2. Mounting device according to claim 1,
**characterised in that** the functional unit is implemented as an electronics module.

3. Mounting device according to claim 1 or 2,
**characterised in that** the functional unit is implemented as an electromotive drive unit (6) positioning the placement head (1).

4. Mounting device according to claim 3,
**characterised in that** the drive unit is implemented as a coil unit (6) of a linear motor.

5. Mounting device according to claim 4,
**characterised in that** the displaceable mounting head (1) is fixed to the coil unit (6) and
the air guide device (19) is implemented in the mounting head (1) as an air guide duct.

6. Mounting device according to one of the preceding claims,
**characterised in that** a plurality of the vacuum grippers (14) are held on a revolver (13) of the mounting head (1) and
the outlet port of the jet pump (17) is connected via the air guide device (19) to a rotary drive (15) for the revolver (13).

7. Mounting device according to claim 5,
**characterised in that** the air guide device (19) has a distributor (20) for distributing the exhaust air to different functional unit

## Revendications

1. Dispositif de montage de composants qui présente au moins une tête de montage (1) de composants qui peut être positionnée, une pompe cinétique (17) d'aspiration d'air qui est associée à une pince aspirante (14) de la tête de montage (1) et qui crée le vide pour la pince aspirante (14), ainsi qu'au moins une unité fonctionnelle (6, 15) sollicitée thermiquement et associée à la tête de montage, la pompe cinétique (17) présentant une ouverture de sortie pour l'air d'échappement, en particulier sur un dispositif de montage de composants électriques (3) sur des substrats (2), **caractérisé en ce que** l'air d'échappement qui s'échappe par l'ouverture de sortie est amené par un dispositif (19) de guidage d'air à l'unité fonctionnelle sollicitée thermiquement.

2. Dispositif de montage selon la revendication 1, **caractérisé en ce que** l'unité fonctionnelle est configurée comme module électronique.

3. Dispositif de montage selon la revendication 1 ou 2, **caractérisé en ce que** l'unité fonctionnelle est configurée comme unité d'entraînement (6) à moteur électrique pour le positionnement de la tête de montage (1).

4. Dispositif de montage selon la revendication 3, **caractérisé en ce que** l'unité d'entraînement est configurée comme unité de bobine (6) d'un moteur linéaire.

5. Dispositif de montage selon la revendication 4, **caractérisé en ce que** la tête de montage (1) déplaçable est reliée solidairement à l'unité de bobine (6) et **en ce que** le dispositif (19) de guidage d'air dans la tête de montage (1) est configuré comme canal de guidage d'air.

6. Dispositif de montage selon l'une des revendications précédentes,
**caractérisé en ce que** plusieurs des pinces aspirantes (14) sont maintenues sur une tourelle (13) de la tête de montage (1) et **en ce que** l'ouverture de sortie de la pompe cinétique (17) est reliée par le dispositif (19) de guidage d'air à un entraînement en rotation (15) de la tourelle (13).

7. Dispositif de montage selon la revendication 5, **caractérisé en ce que** le dispositif (19) de guidage d'air présente un répartiteur (20) pour répartir l'air d'échappement entre les différentes unités fonctionnelles.
